# FASCICULE DE BREVET EUROPEEN

(11) **EP 0 772 047 B1**
(45) Date de publication et mention de la délivrance du brevet: **23.04.2003**
(21) Numéro de dépôt: 96402324.6
(22) Date de dépôt: 31.10.1996
(51) Int. Cl.: G01R 1/07

(54) **Dispositif de mesure de champ électrique**
Anordnung zum Messen eines elektrischen Feldes
Electric field measuring device

(30) Priorité: 03.11.1995 FR 9513000
(43) Date de publication de la demande: 07.05.1997
(73) Titulaire: Thales, 75008 Paris (FR)
(72) Inventeur: Robin, Philippe, c/o Thomson-CSF, SCPI, 94117 Arcueil Cedex (FR); Labeyrie, Michèle, c/o Thomson-CSF, SCPI, 94117 Arcueil Cedex (FR); Dolfi, Daniel, c/o Thomson-CSF, SCPI, 94117 Arcueil Cedex (FR); Chazelas, Jean, c/o Thomson-CSF, SCPI, 94117 Arcueil Cedex (FR)

(56) Documents cités:
- EP-A- 0 616 225
- US-A- 5 255 428
- US-A- 5 434 698

## Description

La présente invention concerne un dispositif de mesure de champ électrique et peut notamment s'appliquer au test d'antennes radar. De façon générale, elle s'applique aux mesures de champ électriques émis par toute surface, réalisées sans amener de perturbations au niveau desdits champs émis, ces mesures étant réalisées pendant la période de test ou pendant la période opérationnelle.

Dans le domaine des antennes radar à balayage électronique, plusieurs systèmes électriques sont utilisés actuellement. Il peut notamment s'agir de petits cornets hyper destinés à recueillir le champ électrique émis au niveau des antennes, le signal électrique ainsi recueilli étant véhiculé par des câbles électriques jusqu'à l'appareil de mesure. Le problème posé par ce type de dispositif réside dans la difficulté de concevoir des éléments de mesure les plus petits possibles et d'éviter les perturbations de mesure dues à la présence de câbles électriques.

Le document US 5 434 698 décrit un dispositif électrooptique comprenant des couches électrooptiques et une couche réflective.

Pour résoudre notamment le problème de perturbation de dispositifs de mesure de champ électrique, mis au voisinage d'une antenne, l'invention a pour objet un dispositif électrooptique de mesure de champ électrique utilisant une onde optique et un matériau électrooptique dont l'indice optique peut varier sous l'influence d'un champ électrique.

Plus précisément, l'invention a pour objet un dispositif de mesure de champ électrique au voisinage d'une surface S caractérisé en ce qu'il comprend :
- un premier élément E₁ apposé sur la surface S et comprenant l'association d'une couche C₁ de matériau électrooptique et d'une couche catadioptrique C₂ ;
- un deuxième élément E₂ indépendant de la surface S et comprenant des moyens d'émission d'une onde optique et des moyens de détection de l'onde optique rétroréfléchie par la couche catadioptrique du premier élément E₁.

La couche de matériau électrooptique peut avantageusement être un film polarisé de polymère électrooptique.

Un des avantages du dispositif de l'invention réside dans sa simplicité, assurée notamment par l'élément E₂ qui combine les moyens d'émission de l'onde optique et les moyens de détection de l'onde optique réfléchie, permettant de balayer facilement l'ensemble de la surface S dont on veut connaître le champ électrique émis, et ce grâce à la présence d'une couche catadioptrique dans l'élément E₁, qui a la propriété de renvoyer un faisceau optique incident, selon une direction parallèle à la direction incidente.

L'invention a aussi pour objet un dispositif de mesure de champ électrique d'une surface S, utilisant une couche de matériau électrooptique à polarisation oblique, l'axe de polarisation faisant un angle non nul avec la normale au plan de ladite couche. Ce type de configuration permet la détection d'un champ électrique parallèle au plan des couches, ce qui constitue un atout majeur dans le cadre de champs électriques émis par des antennes dont la direction de propagation est fréquemment normale au plan des antennes.

La couche catadioptrique C₂ peut avantageusement posséder une surface de contact avec la couche C₁, possédant un relief de microcoins de cube pour assurer la rétroréflexion de l'onde incidence Iₒ, dans la même direction que ladite onde incidente. La couche catadioptrique C₂ peut aussi avantageusement être constituée d'un liant polymère dans lequel sont dispersées des petites billes de verre.

Avantageusement, la surface catadioptrique peut comprendre un revêtement adhésif du côté destiné à être apposé au niveau de la surface S.

L'invention sera mieux comprise et d'autres avantages apparaîtront à la lecture de la description qui va suivre donnée à titre non limitatif et grâce aux figures annexées parmi lesquelles :
- la figure 1 schématise les deux éléments E₁ et E₂ constitutifs du dispositif selon l'invention ;
- la figure 2 illustre un exemple de couche C₂ utilisant un film de polymère électrooptique ;
- la figure 3 illustre l'évolution de l'intensité lumineuse reçue par le photodétecteur en fonction du déphasage crée au niveau de la couche C₂ ;
- la figure 4 illustre un procédé de polarisation d'un film de polymère à polarisation oblique, permettant de détecter des champs électriques parallèles à une surface S.

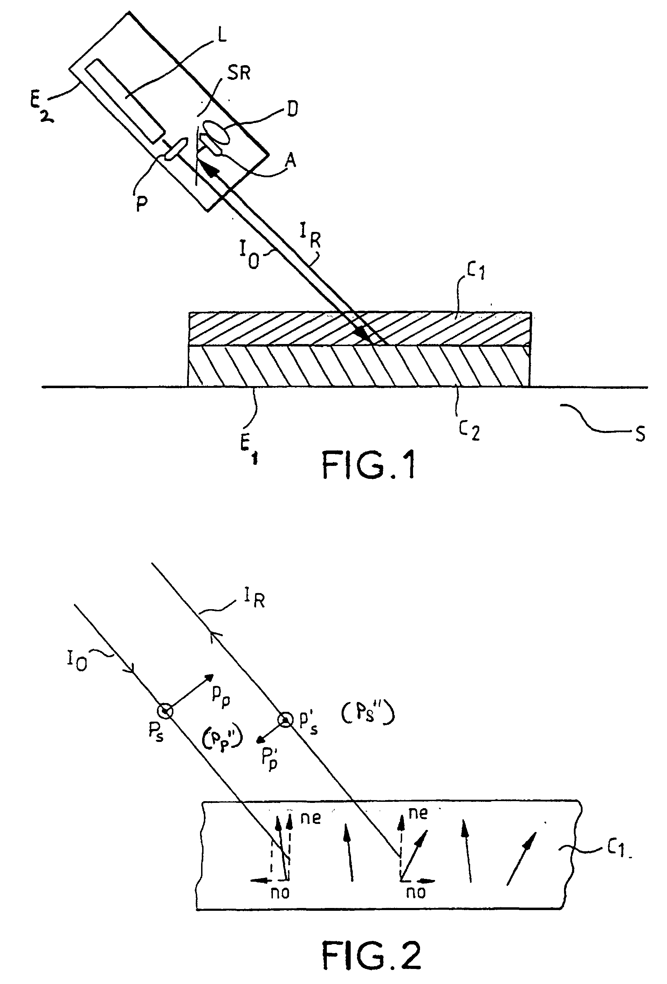

Selon une variante de l'invention, le dispositif de mesure de champ électrique comprend comme l'illustre la figure 1, un élément E₁ déposé au niveau de la surface S dont on cherche à connaître le champ électrique émis.

Cet élément E₁ comprend une couche C₁ de matériau électrooptique et une couche C₂ catadioptrique c'est-à-dire présentant une très bonne réflectivité dans la direction de l'éclairement incident. Le dispositif de mesure de champ électrique comprend également un second élément E₂ équipé d'une source de lumière L pouvant avantageusement être de type laser, d'un polariseur P, permettant d'envoyer sur l'ensemble de l'élément E₁, une onde optique polarisée Iₒ. Cette onde optique est rétroréfléchie par la surface catadioptrique, en une onde optique I_{R} de direction parallèle à l'onde incidente Iₒ vers l'élément E₂. Ledit élément E₂ est également muni d'un photodétecteur D et d'un analyseur A permettant de recueillir l'onde rétroréfléchie, analysée entre polariseurs croisés, puisque les directions de polarisation des deux polariseurs sont orthogonales.

Selon une autre variante de l'invention, l'élément E₁ peut comprendre un unique polariseur, au travers duquel passent l'onde incidente et l'onde réfléchie, la mesure étant effectuée entre polariseurs parallèles.

Une lame semi-réfléchissante SR est utilisée pour diriger l'onde optique réfléchie vers le photodétecteur D.

Lorsque l'ensemble E₁ est soumis à un champ électrique, l'indice optique de la couche de matériau électrooptique, varie, entraînant une rotation de la polarisation de l'onde incidente et par la même une variation d'amplitude du signal recueilli en sortie du photodétecteur D, après passage au travers de l'analyseur A dont la position est fixée par rapport à celle du polariseur P.

La couche de matériau électrooptique peut avantageusement être un film polarisé de polymère électrooptique.

En effet, les polymères électrooptiques sont des polymères qui renferment des groupements actifs en optique non linéaire et qui préalablement polarisés peuvent présenter des propriétés macroscopiques pour constituer des effets électrooptiques. Plus précisément, pour conférer au film polymère une activité électrooptique, il faut le polariser, c'est-à-dire orienter les groupements actifs. Typiquement, un champ électrique continu est appliqué sur le film à une température supérieure à sa température de transition vitreuse. Les groupements actifs qui portent un dipôle s'alignent alors suivant l'axe du champ électrique. Le matériau est ensuite refroidi sous champ électrique et l'orientation est ainsi figée au sein dudit matériau. Le champ électrique peut être coupé : le matériau est électrooptique.

Ce type de matériau présente le grand intérêt d'être facilement déposable sur toute surface. De plus de tels composés organiques possèdent une faible constante diélectrique voisine de 3, inférieure à celle des composés inorganiques, ce qui permet de constituer un élément de test, perturbant peu la mesure du champ électrique, émis au voisinage de la surface S.

Le film de polymère présente alors une biréfringence, se traduisant par un indice ordinaire nₒ parallèle au plan du film et un indice extraordinaire nₑ normal au plan du film, comme l'illustre la figure 2.

Lorsqu'une lumière polarisée dont la polarisation possède une composante pₛ dans le plan normal au plan d'incidence et une composante pₚ dans le plan d'incidence, pénètre dans la couche de matériau électrooptique, elle subit un déphasage se traduisant par une variation des composantes p'ₛ et p'ₚ conduisant à une rotation de ladite polarisation comme illustrée en figure 2 et ce avant même d'avoir appliqué un champ électrique sur le matériau électrooptique.

Il est à noter que la direction de propagation de l'onde incidente est inclinée par rapport à l'axe de polarisation du matériau électrooptique de manière à pouvoir détecter la variation de polarisation recherchée.

Dans le dispositif selon l'invention, en présence du champ émis par la surface S, un déphasage supplémentaire créé par l'effet électrooptique modifie les composantes p'ₛ et p'ₚ en composantes p"ₛ et p"ₚ, la résultante de ces composantes, analysée au niveau de l'élément E₂ au travers d'un analyseur permet de déterminer le déphasage supplémentaire dû à l'effet électrooptique et ainsi de calculer le champ électrique émis.

Dans le cadre d'un champ électrique hyperfréquence émis par une antenne, les composantes p"ₛ et p"ₚ sont modulées à la fréquence hyper du champ électrique.

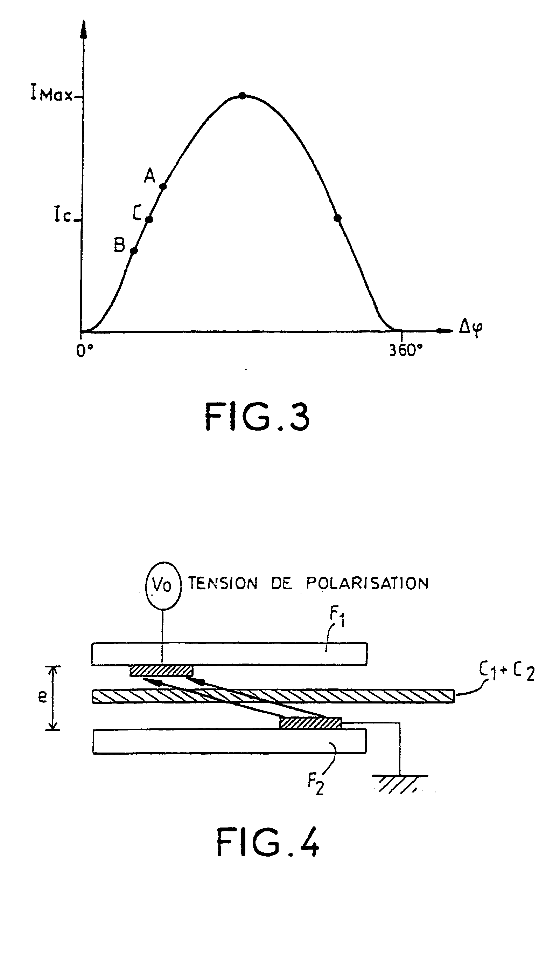

Il est à noter que le déphasage introduit par effet électrooptique reste généralement faible, il peut donc être avantageux d'introduire dans le dispositif un déphaseur type compensateur de Babinet permettant de se placer dans des conditions particulièrement sensibles à toute variation de déphasage. Plus précisément, comme l'illustre la figure 3 qui traduit l'évolution de l'intensité lumineuse reçue au niveau du photodétecteur en fonction du déphasage crée, il apparaît qu'il peut être particulièrement judicieux de se trouver dans une région de la courbe ou la pente est très abrupte définie par les points (A, B, C) sur ladite courbe. Le déphaseur utilisé pour jouer cette fonction d'ajustement sur la courbe de la figure 3, est placé dans l'élément E₂, au niveau de la réception de l'onde optique rétroréfléchie.

Dans le cadre d'applications concernant la détection de champs hyperfréquences, le photodétecteur inclus dans l'élément E₂ peut être une photodiode rapide dont la bande passante est compatible avec les champs à mesurer, donc capable de fonctionner à des cadences supérieures typiquement à 10 GHz. Le signal électrique issu de la photodiode est alors directement proportionnel à la valeur instantanée du champ électrique hyperfréquence à mesurer.

Selon une variante de l'invention, le dispositif de mesure de champ électrique est particulièrement adapté à la détection de champs électriques parallèles à la surface S. Pour cela, le dispositif comprend une couche de matériau présentant une polarisation oblique. Le matériau peut avantageusement être un film de polymère électrooptique polarisé selon le processus illustré dans le cadre d'un polymère électrooptique de type copolymère de méthacrylate de méthyl et de 4(M-méthacryloylox ethyl N éthyl amin)4' nitroazobenzène (décrit dans la publication : Liquid Crystals (1993 vol 14, 197-213 J.C. Dubois, P. Le Barny, P. Robin, V. Lemoine and H. Rajbenbach).

Le substrat choisi est la couche C₂ catadioptrique, munie d'un revêtement adhésif en face inférieure.

Le polymère électrooptique est déposé sur la face supérieure du substrat, à la toumette en utilisant du 1.1.2 trichloroéthane en concentration de 100 g/l. Typiquement une rotation de 3000 trs/min permet d'obtenir des épaisseurs de l'ordre du micron. Des solutions plus concentrées et des vitesses de rotation plus faible conduisent à des épaisseurs plus élevées.

Après une étape de séchage, éventuellement sous vide, le film de polymère peut être polarisé.

Des électrodes F₁ et F₂ sont disposées sur deux supports isolants (par exemple aluminium sur verre). Comme illustré en figure 4, ces supports, séparés d'une distance e, sont arrangés de manière à créer un champ électrique de polarisation, oblique. L'un des supports est mis à la masse et l'ensemble film de polymère sur surface catadioptrique est placé dans l'enceinte ainsi constituée. Le film est chauffé jusqu'à une température supérieure à la température de transition vitreuse du polymère (typiquement 110°C pour les copolymères de PMMA). Le champ électrique est appliqué en portant l'électrode qui n'est pas à la masse, à un potentiel +Vo (Vole étant de l'ordre de 100 V/micron). Après quelques minutes, la température est ramenée à l'ambiante et l'orientation du matériau est gelée. Le champ électrique peut être supprimé, et le film de polymère retiré de l'enceinte constituée par les deux supports munis d'électrodes.

L'ensemble film de polymère à polarisation oblique, surface catadioptrique, revêtement adhésif, peut alors être apposé sur la surface S considérée.

## Revendications

1. Dispositif de mesure de champ électrique au voisinage d'une surface (S) **caractérisé en ce qu'**il comprend :
- un premier élément (E₁) comprenant l'association d'une couche (C₁) de matériau électrooptique et d'une couche catadioptrique (C₂), ledit premier élément destiné à être déposé sur la surface (S) ;
- - un deuxième élément (E₂) destiné à être indépendant de la surface (S) et comprenant des moyens d'émission d'une onde optique et des moyens de détection de l'onde optique rétroréfléchie par la couche catadioptrique du premier élément (E₁).

2. Dispositif de mesure de champ électrique selon la revendication 1, **caractérisé en ce que** le matériau électrooptique présente un axe de polarisation, destiné à être incliné par rapport à la normale à la surface (S) de manière à permettre la détection du champ électrique parallèle à la surface (S).

3. Dispositif de mesure de champ électrique selon l'une des revendications 1 ou 2, **caractérisé en ce que** la couche de matériau électrooptique est un film polarisé de polymère électrooptique.

4. Dispositif de mesure de champ électrique selon l'une des revendications 1 à 3, **caractérisé en ce que** la direction de propagation de l'onde optique est destinée à être inclinée par rapport à la normale à la surface (S).

5. Dispositif de mesure de champ électrique selon l'une des revendications 1 à 4, **caractérisé en ce que** la couche catadioptrique (C₂) possède une surface de contact avec la couche (C₁) de matériau électrooptique présentant un relief de microcoins de cube.

6. Dispositif de mesure de champ électrique selon l'une des revendications 1 à 4, **caractérisé en ce que** la couche catadioptrique (C₂) est constituée d'un liant polymère dans lequel sont dispersées des petites billes de verre.

7. Dispositif de mesure de champ électrique selon l'une des revendications 1 à 6, **caractérisé en ce que** le deuxième élément (E₂) comprend un polariseur et un analyseur de manière à mesurer le champ électrique émis par la surface (S), par mesure de rotation de polarisation entre l'onde optique émise (Iₒ) et l'onde optique réfléchie (I_{R}).

8. Dispositif de mesure de champ électrique selon la revendication 7, **caractérisé en ce que** le deuxième élément (E₂) comprend un compensateur de Babinet.

9. Dispositif de mesure de champ électrique selon l'une des revendications 1 à 8, **caractérisé en ce que** la couche catadioptrique (C₂) comprend un revêtement adhésif sur la surface opposée à la surface de contact avec la couche (C₁) de matériau électrooptique.

## Patentansprüche

1. Vorrichtung zum Messen des elektrischen Feldes in der Umgebung einer Oberfläche (S), **dadurch gekennzeichnet, daß** sie umfaßt:
- ein erstes Element (E₁) das die Zuordnung einer ersten Schicht (C₁) aus einem elektrooptischen Material und aus einer katadioptrischen Schicht (C₂) umfaßt, wobei das erste Element auf der Oberfläche (S) abgelagert werden soll;
- ein zweites Element (E₂), das von der Oberfläche (S) unabhängig sein soll und Mittel zum Senden einer Lichtwelle sowie Mittel zum Erfassen der Lichtwelle, die von der katadioptrischen Schicht des ersten Elements (E₁) reflektiert wird, umfaßt.

2. Vorrichtung zum Messen eines elektrischen Feldes nach Anspruch 1, **dadurch gekennzeichnet, daß** das elektrooptische Material eine Polarisationsachse aufweist, die in bezug auf die Normale der Oberfläche (S) geneigt sein soll, so daß die Erfassung des zu der Oberfläche (S) parallelen elektrischen Feldes ermöglicht wird.

3. Vorrichtung zum Messen eines elektrischen Feldes nach einem der Ansprüche 1 oder 2, **dadurch gekennzeichnet, daß** die Schicht aus elektrooptischem Material ein polarisierter Film aus einem elektrooptischem Polymer ist.

4. Vorrichtung zum Messen eines elektrischen Feldes nach einem der Ansprüche 1 bis 3, **dadurch gekennzeichnet, daß** die Ausbreitungsrichtung der Lichtwelle in bezug auf die Normale der Oberfläche (S) geneigt sein soll.

5. Vorrichtung zum Messen eines elektrischen Feldes nach einem der Ansprüche 1 bis 4, **dadurch gekennzeichnet, daß** die katadioptrische Schicht (C₂) eine Kontaktoberfläche mit der Schicht (C₁) aus einem elektrooptischen Material besitzt, die ein Relief aus kubischen Mikrokeilen aufweist.

6. Vorrichtung zum Messen eines elektrischen Feldes nach einem der Ansprüche 1 bis 4, **dadurch gekennzeichnet, daß** die katadioptrische Schicht (C₂) aus einem polymeren Bindungsmittel gebildet ist, in dem kleine Glaskugeln dispergiert sind.

7. Vorrichtung zum Messen eines elektrischen Feldes nach einem der Ansprüche 1 bis 6, **dadurch gekennzeichnet, daß** das zweite Element (E₂) einen Polarisator und einen Analysator umfaßt, um ein von der Oberfläche (S) ausgesendetes elektrisches Feld durch Messen der Polarisationsdrehung zwischen der ausgesendeten Lichtquelle (I₀) und der reflektierten Lichtwelle (I_{R}) zu messen.

8. Vorrichtung zum Messen eines elektrischen Feldes nach Anspruch 7, **dadurch gekennzeichnet, daß** das zweite Element (E₂) einen Babinet-Konpensator enthält.

9. Vorrichtung zum Messen eines elektrischen Feldes nach einem der Ansprüche 1 bis 8, **dadurch gekennzeichnet, daß** die katadioptrische Schicht (C₂) auf der der Kontaktoberfläche mit der Schicht (C₁) aus elektrooptischem Material gegenüberliegenden Oberfläche eine Haftbeschichtung aufweist.

## Claims

1. Device for measuring an electric field in the vicinity of a surface (S), **characterized in that** it comprises:
- a first element (E₁) comprising the combination of a layer (C₁) of electrooptic material and of a catadioptric layer (C₂), the said first element intended to be deposited on the surface (S); and
- a second element (E₂) intended to be independent of the surface (S) and comprising means for emitting an optical wave and means for detecting the optical wave back-reflected by the catadioptric layer of the first element (E₁).

2. Electric field measuring device according to Claim 1, **characterized in that** the electrooptic material has a polarization axis intended to be inclined to the normal to the surface (S) so as to allow detection of the electric field parallel to the surface (S).

3. Electric field measuring device according to either of Claims 1 and 2, **characterized in that** the layer of electrooptic material is a polarized film of an electrooptic polymer.

4. Electric field measuring device according to one of Claims 1 to 3, **characterized in that** the direction of propagation of the optical wave is intended to be inclined to the normal to the surface (S).

5. Electric field measuring device according to one of Claims 1 to 4, **characterized in that** the catadioptric layer (C₂) has a surface for contact with the layer (C₁) of electrooptic material having a relief consisting of cube microcorners.

6. Electric field measuring device according to one of Claims 1 to 4, **characterized in that** the catadioptric layer (C₂) consists of a polymer binder in which small glass spheres are dispersed.

7. Electric field measuring device according to one of Claims 1 to 6, **characterized in that** the second element (E₂) comprises a polarizer and an analyser so as to measure the electric field emitted by the surface (S) by measuring the polarization rotation between the emitted optical wave (I_{O}) and the reflected optical wave (I_{R}).

8. Electric field measuring device according to Claim 7, **characterized in that** the second element (E₂) comprises a Babinet compensator.

9. Electric field measuring device according to one of Claims 1 to 8, **characterized in that** the catadioptric layer (C₂) includes an adhesive coating on the surface on the opposite side from the surface of contact with the layer (C₁) of electrooptric material.
